# FASCICULE DE BREVET EUROPEEN

(11) **EP 3 276 673 B1**
(45) Date de publication et mention de la délivrance du brevet: **22.04.2020**
(21) Numéro de dépôt: 17183056.5
(22) Date de dépôt: 25.07.2017
(51) Int. Cl.: H01L 31/042, H01L 31/05, H01L 31/18

(54) **PROCEDE DE FABRICATION D'UN ELEMENT PHOTOVOLTAÏQUE**
HERSTELLUNGSVERFAHREN EINES FOTOVOLTAIKELEMENTS
METHOD FOR MANUFACTURING A PHOTOVOLTAIC ELEMENT

(30) Priorité: 29.07.2016 FR 1657388
(43) Date de publication de la demande: 31.01.2018
(73) Titulaire: Commissariat à l'énergie atomique et aux énergies alternatives, 75015 Paris (FR)
(72) Inventeur: VESCHETTI, Yannick, 38480 Saint-Martin de Vaulserre (FR); BERTRAND, David, 73000 Chambery (FR); MESSAOUDI, Paul, 73230 Saint-Alban Leysse (FR); PILAT, Eric, 73100 Brison-Saint-Innocent (FR); QUESNEL, François, 73000 Bassens (FR); THONY, Philippe, 38380 Entre-deux-Guiers (FR)
(74) Mandataire: Brevalex

(56) Documents cités:
- US-A1- 2013 139 871
- US-A1- 2015 090 314

## Description

### DOMAINE TECHNIQUE

La présente invention concerne un procédé de fabrication d'un élément photovoltaïque. Plus particulièrement, la présente invention concerne un procédé de fabrication d'un élément photovoltaïque permettant d'augmenter la tension de panneaux photovoltaïques.

### DOMAINE TECHNIQUE ET ART ANTÉRIEUR

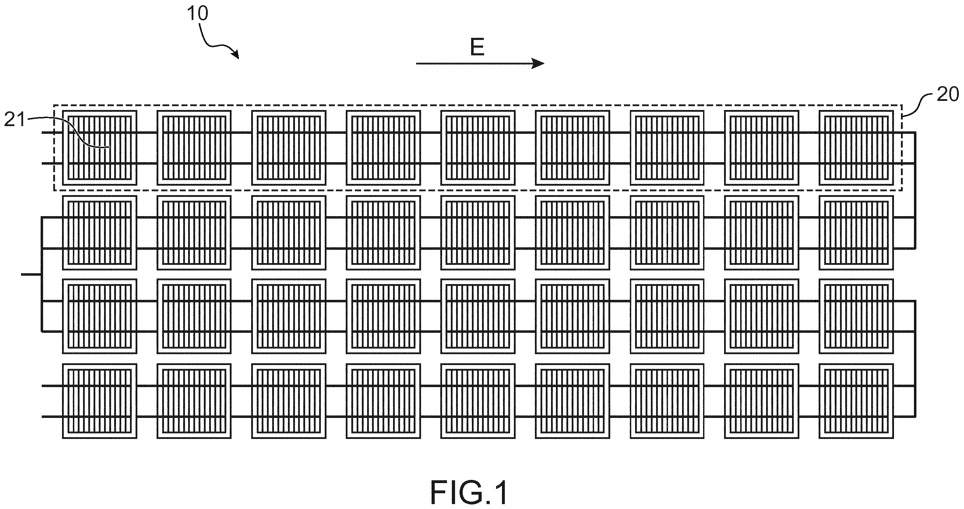

Un panneau photovoltaïque 10 présenté à la figure 1 comprend, en général, une pluralité de rangées 20 de cellules photovoltaïques 21, s'étendant chacune selon une direction d'élongation E, et parallèles entre elles. L'ensemble des cellules photovoltaïques 21 sont connectées en série de sorte que la tension finale du panneau photovoltaïque 10 est imposée par la somme des tensions de chaque cellule photovoltaïque 21. Certaines applications peuvent nécessiter la conception de panneaux photovoltaïques 10 présentant une tension plus élevée, notamment, soit pour des applications dans le bâtiment, soit pour réduire le coût de l'énergie photovoltaïque.

Selon une première approche, l'homme du métier peut alors considérer l'utilisation de cellules photovoltaïques 21 présentant une tension plus élevée que celle des cellules photovoltaïques traditionnellement utilisées. Cependant, l'augmentation de la tension d'une cellule photovoltaïque 21 nécessite une isolation particulièrement complexe à mettre en œuvre.

A cet égard, le document [1] cité à la fin de la description propose un report d'une cellule photovoltaïque en silicium sur un substrat de silicium fritté. Le report est suivi d'une découpe au laser de la cellule photovoltaïque par formation de tranchées sur toute l'épaisseur de la cellule afin de former des sous cellules photovoltaïques (les tranchées peuvent pénétrer partiellement le silicium frittée sans pour autant affecter son intégrité mécanique). Le substrat de silicium fritté est alors oxydé sélectivement au niveau des tranchées, et sur toute son épaisseur, de manière à assurer une isolation électrique entre les sous cellules photovoltaïque. Les sous cellules sont ensuite connectées entre elles par des étapes de métallisation. Cependant, ce procédé n'a pas encore été validé à l'échelle industrielle et n'est pas compatible avec les procédés industriels de connexion électrique de cellules photovoltaïque.

Toujours avec l'objectif d'augmenter la tension d'une cellule photovoltaïque, les documents [2]-[4] proposent la découpe d'une cellule photovoltaïque comprenant une alternance de jonctions PN de manière à former une pluralité de jonctions PN. Une étape de métallisation permet ensuite de contacter électriquement les jonctions PN entre elles. Cependant, ce procédé est limité à des cellules photovoltaïques monolithique de type IBC (IBC pour « Interdigitated Back Contact » selon la terminologie Anglo-Saxonne).

Selon une deuxième approche, tel que proposé dans les documents [5]-[8] cités à la fin de la description, l'augmentation de la tension d'un panneau photovoltaïque 10 peut comprendre l'augmentation du nombre de cellules photovoltaïques 21. Cependant, afin de ne pas affecter, ou à tout le moins limiter, la taille du panneau photovoltaïque, il peut être nécessaire de réduire la taille des cellules photovoltaïques 21.

Cette approche n'est pas non plus satisfaisante.

En effet, les équipements de production sont conçus pour manipuler des cellules d'une taille donnée. Par conséquents, la manipulation de cellules de plus petite taille nécessite d'adapter, voire de remplacer, les équipements industriels.

Par ailleurs, l'augmentation du nombre de cellules photovoltaïque complexifie le tri des cellules, et impacte directement le coût de fabrication.

En outre, la réduction de la tailles des cellules risque de ralentir les cadences de production et donc d'impacter les coûts de fabrication.

Selon une autre approche, le document US 2013/139871 A1 décrit un procédé de fabrication d'un élément photovoltaïque comprenant: une étape de connexion électrique en série d'une pluralité de cellules photovoltaïques agencées selon une rangée, la connexion entre deux cellules photovoltaïques adjacentes étant assurée par une pluralité de pistes conductrices; une étape de découpe laser de chaque cellule photovoltaïque en une pluralité de sous-cellules photovoltaïques de manière à former une pluralité de sous-rangées de sous-cellules photovoltaïques, les sous-cellules dans chaque sous-rangée étant connectées en série; et une étape de connexion électrique des sous-rangées de sous-cellules, de sorte que les sous-cellules des sous-rangées soient connectées en série.

Un but de la présente invention est donc de proposer un procédé de fabrication d'un élément photovoltaïque permettant l'augmentation de la tension d'un panneau photovoltaïque.

Un autre but de l'invention est de proposer un procédé de fabrication d'un élément photovoltaïque nécessitant peu ou pas de modifications d'une ligne de production standard.

### EXPOSÉ DE L'INVENTION

Les buts de l'invention sont atteints par un procédé de fabrication d'un élément photovoltaïque comprenant :
a) une étape de connexion électrique en série d'une pluralité de cellules photovoltaïques, comprenant une première face et une seconde face, agencées selon une rangée, ladite rangée s'étendant selon une direction E, la connexion entre deux cellules photovoltaïques adjacentes étant assurée par une pluralité de piste conductrices ;
b) une étape de découpe, le long de lignes de coupe disposées sur la première face, de chaque cellule photovoltaïque en une pluralité de sous-cellules photovoltaïques, l'étape de découpe étant exécutée selon la direction E de manière à former une pluralité de sous-rangées de sous-cellules photovoltaïques, l'étape de découpe étant également exécutée de manière à ce que, dans chaque sous-rangée, les sous-cellules sont connectées en série, l'étape b) comprenant un clivage des cellules photovoltaïques par action mécanique au niveau des lignes de coupe;
c) une étape de connexion électrique d'au moins deux sous-rangées de sous-cellules, de sorte que toutes les sous-cellules des au moins deux sous-rangées soient connectées en série,
le procédé comprend en outre une étape a1), précédant l'étape b), avantageusement l'étape a), ladite étape a1) étant une étape de fragilisation le long des lignes de coupe de chaque cellule photovoltaïque,
l'étape a1) comprenant la formation de tranchées selon les lignes de coupe dans les cellules photovoltaïques, avantageusement, la formation des tranchées étant exécutée par un traitement LASER, les tranchées s'étendant sur une profondeur P, à partir de la première face ou de la seconde face, comprise entre 2,5 % et 50 % de l'épaisseur totale de la cellule photovoltaïque et avantageusement entre 5% et 20% de l'épaisseur totale.

Ainsi, la tension des sous-rangées de sous-cellules photovoltaïque présente une tension supérieure à la tension de la rangée à partir de laquelle lesdites sous rangées ont été obtenu. Cette augmentation de tension peut ainsi être atteinte sans modification de la ligne de production considérée.

Par ailleurs, les étapes de tri de cellules ne sont pas non plus impactées.

L'étape de fragilisation permet une étape b comprenant un clivage par simple application de pression. Autrement dit, l'étape b) ne nécessite pas des équipements compliqués et coûteux à mettre en œuvre.

Selon un mode de réalisation, le procédé comprend le mise en place d'un Im de maintien sur la seconde face avant l'étape a), avantageusement des ouvertures sont ménagées dans le film de maintien pour permettre un contact électrique entre les pistes conductrices et la seconde face.

Selon l'invention, l'étape a1. comprend la formation de tranchées selon les lignes de coupe dans les cellules photovoltaïques, avantageusement, la formation des tranchées est exécutée par un traitement LASER.

Selon l'invention, l'étape b. comprend un clivage des cellules photovoltaïques par action mécanique au niveau des lignes de coupe.

Selon un mode de réalisation, l'étape b. est exécutée de sorte à laisser un espacement entre les sous-rangées.

Il est ainsi possible d'ajuster la transparence de panneau photovoltaïque comprenant les sous-rangées formées par le procédé selon l'invention en ajustant l'espacement desdites sous-rangées.

Cet effet est particulièrement intéressant pour ajuster l'ombrage de cultures par exemple.

Il est également intéressant pour des applications dans le bâtiment (les bâtiments domestiques par exemple).

Selon un mode de réalisation, l'étape c. est précédée du retrait d'au moins une sous-rangée de manière à laisser un espace libre entre deux sous-rangées.

Il est ainsi possible d'ajuster la transparence de panneaux photovoltaïques comprenant les sous-rangées formées par le procédé selon l'invention en supprimant certaines desdites sous-rangées.

Cet effet est particulièrement intéressant pour ajuster l'ombrage de cultures par exemple.

Il est également intéressant pour des applications dans le bâtiment (les bâtiments domestiques par exemple).

L'invention concerne également un fabrication d'un panneau photovoltaïque comprenant le mise en place de sous-rangées de sous-cellules photovoltaïques sur un support transparent, électriquement connectées en série.

Selon un mode de réalisation, la mise place de sous-rangées de sous-cellules photovoltaïques est suivie d'une étape de lamination destinée à enrober l'ensemble des sous-cellules photovoltaïques.

### BRÈVE DESCRIPTION DES DESSINS

D'autres caractéristiques et avantages apparaîtront dans la description qui va suivre du procédé de fabrication d'un élément photovoltaïque selon l'invention, donnés à titre d'exemples non limitatifs, en référence aux dessins annexés dans lesquels :
- la figure 1 est une représentation schématique d'un panneau photovoltaïque, connu de l'état de la technique, comprenant des cellules photovoltaïques électriquement connectées en série et arrangées sous forme de rangées ;
- la figure 2a est une représentation schématique d'une rangée de cellule photovoltaïques électriquement connectées en série par la face avant de ladite rangée, selon l'invention ;
- la figure 2b est une vue en coupe DD' de la rangée représentée à la figure 2a selon l'invention ;
- la figure 2c est un grossissement de la figure 2b ;
- la figure 2d est une représentation schématique des connexions électriques par les pistes conductrices selon l'invention ;
- la figure 3a est une représentation schématique de l'étape b. selon l'invention, la figure 3a représente également l'espacement entre sous-rangées selon le direction L ;
- la figure 3b est une représentation schématique de sous-rangées formées à partir d'une seule rangée, et après suppression (retrait) d'une sous rangées (représentée en traits interrompus) ;
- la figure 4a est une représentation schématique d'une cellule photovoltaïque après la formation de tranchées ;
- la figure 4b est une représentation schématique d'une cellule photovoltaïque comprenant des tranchées sur sa première face et un film de maintien préalablement déposé avant la formation des tranchées ;
- la figure 4c est une vue par le seconde face d'une cellule photovoltaïque comprenant le film de maintien disposé sur ladite seconde face, ledit film comprenant des ouvertures.
- la figure 5 est une représentation de sous rangées comprenant des sous-cellules toutes connectées en séries ;
- les figures 6a et 6b sont des représentations schématiques de dispositifs de clivages des cellules photovoltaïques ;
- la figure 7 est une représentation schématique de l'assemblage de sous-rangées de sous-cellules photovoltaïques destiné à former un panneau photovoltaïque.

### EXPOSÉ DÉTAILLÉ DE MODES DE RÉALISATION PARTICULIERS

L'invention décrite de manière détaillée ci-dessous met en œuvre un procédé de fabrication d'un élément photovoltaïque, destiné à permettre l'augmentation de la tension de panneaux photovoltaïques comprenant des cellules photovoltaïques.

Le procédé selon l'invention propose l'assemblage de cellules photovoltaïques comprenant une étape de découpe desdites cellules photovoltaïques après formation des connexions électriques.

L'étape de découpe des cellules photovoltaïques à un stade avancé du procédé d'assemblage est particulièrement avantageuse puisqu'elle permet d'utiliser des lignes de production de panneaux photovoltaïques existantes. Par ailleurs, l'augmentation de la tension des panneaux photovoltaïques est obtenue par une démultiplication du nombre de cellules photovoltaïques comprises dans le panneau photovoltaïque sans affecter sa taille et sans nécessiter la manipulation de cellules photovoltaïques de plus petite taille.

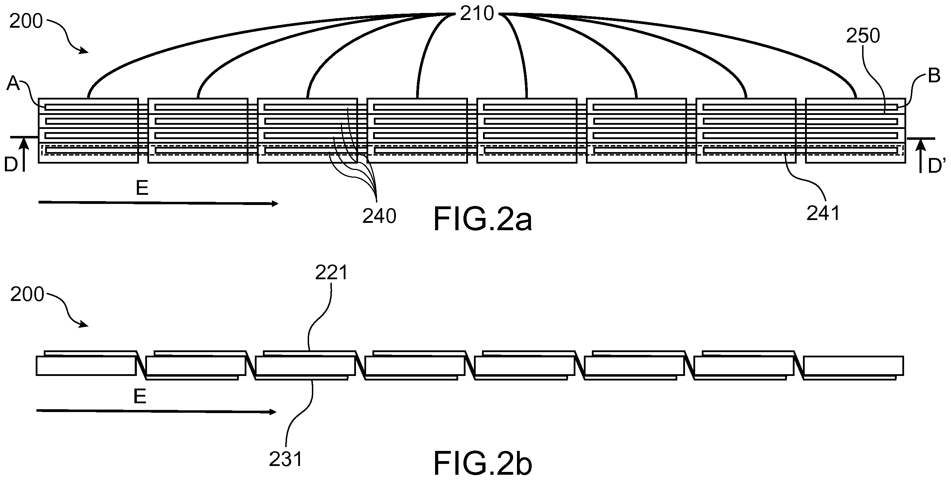

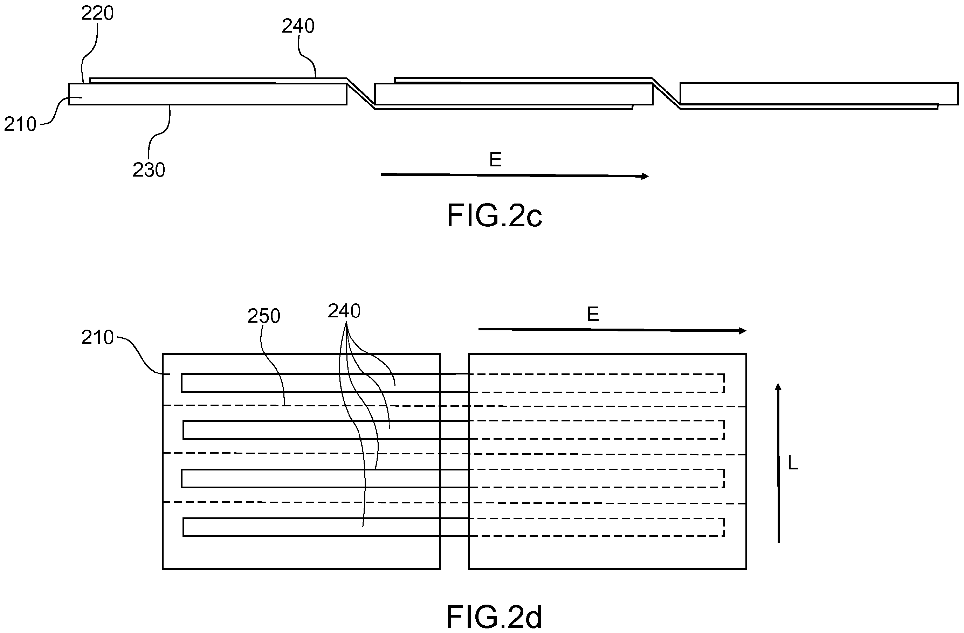

Sur les figures 2 à 6, on peut voir un exemple de mise œuvre du procédé de fabrication d'un élément photovoltaïque selon l'invention.

Le procédé selon l'invention comprend une étape a. (figure 2a) de connexion électrique en série d'une pluralité de cellules photovoltaïques 210 agencée selon une rangée 200, ladite rangée s'étendant selon une direction E (nous entendons par direction E, une direction d'élongation E).

Les cellules photovoltaïques 210 peuvent être de forme carrée, par exemple de 156 mm de côté.

L'épaisseur des cellules photovoltaïques 210 peut être comprise entre 150 µm et 180 µm.

Les cellules photovoltaïques 210 peuvent être des cellules de silicium, des cellules multi jonction.

A l'issue de l'étape a., les cellules photovoltaïques 210 sont électriquement connectées (ci-après « connectées ») en série, de sorte que la tension aux bornes A et B d'une même rangée 200 est égale à la somme des tensions aux bornes cellules photovoltaïques 210 qui composent ladite rangée 200.

Les cellules photovoltaïques 210 comprennent une première face 220 et une seconde face 230 essentiellement parallèles entre elles (figure 2c).

Une rangée 200 comprend deux faces opposées et parallèles entre elles dites « face avant 221 » et « face arrière 231 » (figure 2b). Les cellules photovoltaïques 210 de la rangée 200 sont disposées de sorte que l'ensemble des premières faces 220 coïncide avec la face avant 221 de ladite rangée. De manière équivalente, l'ensemble des secondes faces 230 des cellules photovoltaïques 210 de la rangée 200 coïncident avec la face arrière 231 de ladite rangée.

La connexion électrique de deux cellules photovoltaïques 210 immédiatement adjacentes de la rangée 200 est assurée par une pluralité de pistes conductrices 240 s'étendant selon la direction E (figure 2a). Plus particulièrement, la pluralité de pistes conductrices 240 connecte la première face 220 d'une des deux cellules photovoltaïques 210 avec la seconde face 230 de l'autre des deux cellules photovoltaïques 210. Ainsi, selon ce mode de connexion, tel que représenté à la figure 2b, l'ensemble des cellules photovoltaïques 210 d'une rangée sont électriquement connectées en série.

Les pistes conductrices 240 connectant électriquement deux cellules photovoltaïques peuvent être parallèles entre elles selon la direction E, et peuvent présenter un espacement régulier selon la direction latérale L.

Nous entendons par direction latérale L, une direction perpendiculaire à la direction E et parallèle à la face avant 221 (et la face arrière 231).

Le nombre de pistes conductrices 240 peut être le même sur chacune des faces de chacune des cellules photovoltaïques 210. Dans ce cas de figure, chaque piste conductrice 240 disposée sur une face d'une cellule photovoltaïque 210 peut être en regard d'une autre piste conductrice 240 disposée sur l'autre face de ladite cellule, de sorte à former des lignées 241 de pistes conductrices 240 (encadré en traits interrompus figure 2a).

Par lignée 241 de pistes conductrices 240, nous entendons que l'intersection d'un plan perpendiculaire à la face avant 221 comprend des pistes conductrices 240 connectant en série toutes les cellules photovoltaïques 210 de ladite rangée 200.

Une piste conductrice 240 peut comprendre au moins un des matériaux choisi parmi : cuivre, aluminium, argent, or, platine, fer et graphite.

Chaque piste conductrice 240 peut être collée ou soudée selon des techniques connues de l'homme du métier.

L'étape a. de connexion électrique en série des cellules photovoltaïques 210 peut, par exemple, être exécutée par un équipement dit « Stringer » selon la terminologie Anglo-Saxonne.

A cet égard, l'homme du métier pourra consulter le document [9], cité à la fin de la description, qui décrit le principe de fonctionnement d'un « Stringer ».

L'invention n'est cependant pas limitée à l'utilisation du « Stringer » du document [9].

Nous notons dès à présent que pour l'exécution de l'étape a., l'équipement d'assemblage considéré est destiné à manipuler un type (une taille) de cellule prédéterminé. Autrement dit, ledit équipement n'a subi aucune modification.

Le procédé selon l'invention comprend également une étape b. de découpe des cellules photovoltaïques 210.

Par découpe, nous entendons la séparation mécanique d'une cellule photovoltaïque en une pluralité de sous-cellules photovoltaïques. La découpe comprend un clivage.

L'étape de découpe est exécutée selon des lignes de coupe 250 (figure 2a et figure 2d) disposées sur la première face 220 de chaque cellules photovoltaïques 210.

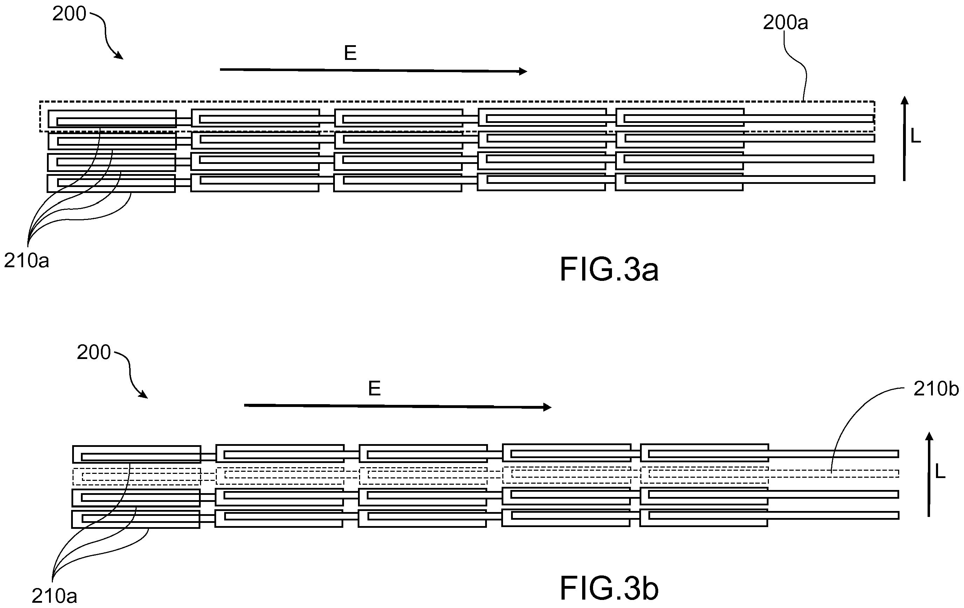

L'étape b. est donc destinée à diviser chaque cellule photovoltaïque 210 en une pluralité de sous-cellules photovoltaïques 210a (figures 3a et 3b).

Par ailleurs, tel qu'illustré aux figures 3a et 3b, l'étape b. est exécutée selon la direction E de manière à former une pluralité de sous-rangées 200a de sous-cellules photovoltaïques 210a, lesdites sous-rangées 200a étant parallèles entre elles selon la direction E.

Par sous-rangée 200a de sous-cellules photovoltaïques 210a, nous entendons des sous-cellules 210a agencées selon une rangée (la sous-rangée 200a) et électriquement connectées en série.

L'étape b. de découpe peut être réalisée sur toute la longueur de la rangée 200 de manière rectiligne, par exemple, entre les lignées 241 de pistes conductrices 240.

Lors de l'étape b. de découpe, chaque cellule photovoltaïque 210 d'une rangée 200 peut être divisée en un même nombre de sous-cellules photovoltaïques 210a.

Plus particulièrement, toutes les sous-cellules photovoltaïques 210a formées à partir des cellules photovoltaïques 210 d'une rangée 200 donnée peuvent être identiques (Par identique, nous entendons des sous-cellules photovoltaïques 210a, essentiellement, de même largeur, de même longueur et de même épaisseur). Ainsi, toutes les sous-cellules photovoltaïques 210a présentent essentiellement la même tension.

L'étape b. met en œuvre une étape de clivage, également connue de l'homme du métier.

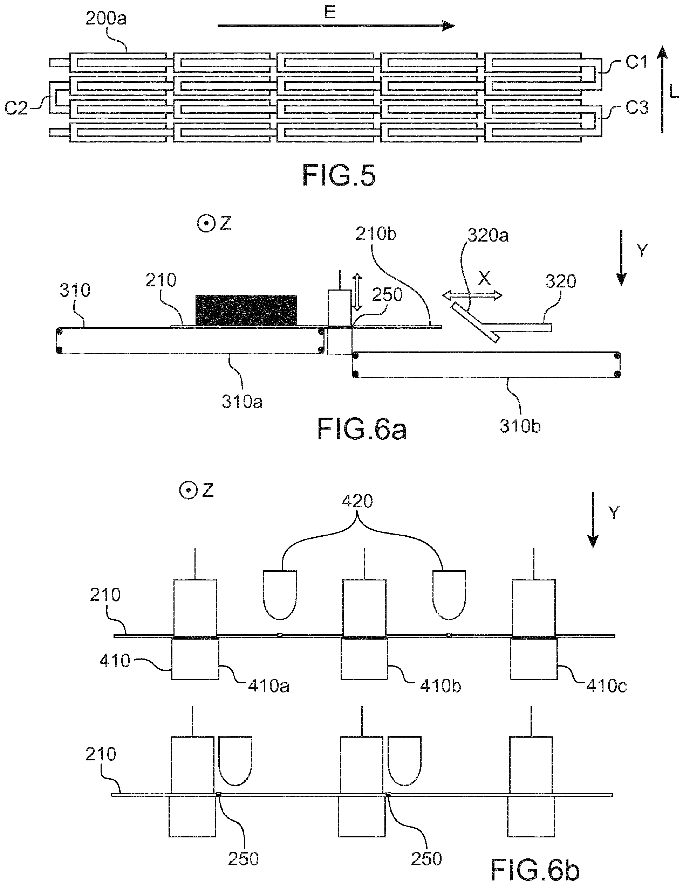

La figure 6a présente un dispositif de clivage comprenant un convoyeur 310 adapté pour convoyer les cellules photovoltaïques 210 selon la direction Y. Le convoyeur 310 comprend au moins deux sous-convoyeurs 310a et 310b décalés l'un par rapport à l'autre selon la direction Y. Le dispositif de clivage comprend également des moyens de déflection 320 adaptés pour exercer une action mécanique sur la cellule photovoltaïque 210 selon la direction Y et ainsi exécuter un clivage de ladite cellule photovoltaïque 210. Les moyens de déflection 320 peuvent comprendre un plan incliné 320a par rapport à la première face 220 de la cellule photovoltaïque. Le déplacement du plan incliné 320a selon la direction X lui permet d'exercer une action mécanique dès qu'il est en butée avec le bord 210b de la cellule photovoltaïque 210.

La figure 6b présente un autre dispositif de clivage comprenant des moyens de maintien 410a, 410b, et 410c de la cellule photovoltaïque 210, ainsi que des moyens de déflection 420 adaptés pour exercer une action mécanique sur la cellule photovoltaïque 210 selon la direction Y. Les moyens de déflection 420 peuvent être un élément massif, qui par déplacement selon la direction Y exercent une pression au niveau des lignes de coupe 250.

L'étape b. peut être également être réalisée de manière à laisser un espacement entre les sous-rangées 200a (figure 3a).

Par espacement entre les sous-rangées, nous entendons un écartement des sous-rangées adjacentes selon la direction latérale L.

Ainsi, en procédant à cet écartement, on peut faire varier la transparence de panneaux photovoltaïques intégrant les sous-rangées 200a.

Il est également possible de faire varier la transparence d'un panneau photovoltaïque en retirant au moins une sous-rangée 200a de chaque rangée 200 intégrée dans ledit panneau photovoltaïque (sur la figure 3b, la sous-rangée 210b représentée en traits interrompus est retirée).

L'étape b. de découpe est précédée d'une étape a1. de fragilisation de chaque cellule photovoltaïque 210 le long des lignes de coupe 250.

Par étape a1. de fragilisation, nous entendons une étape destinée à faciliter l'étape de découpe.

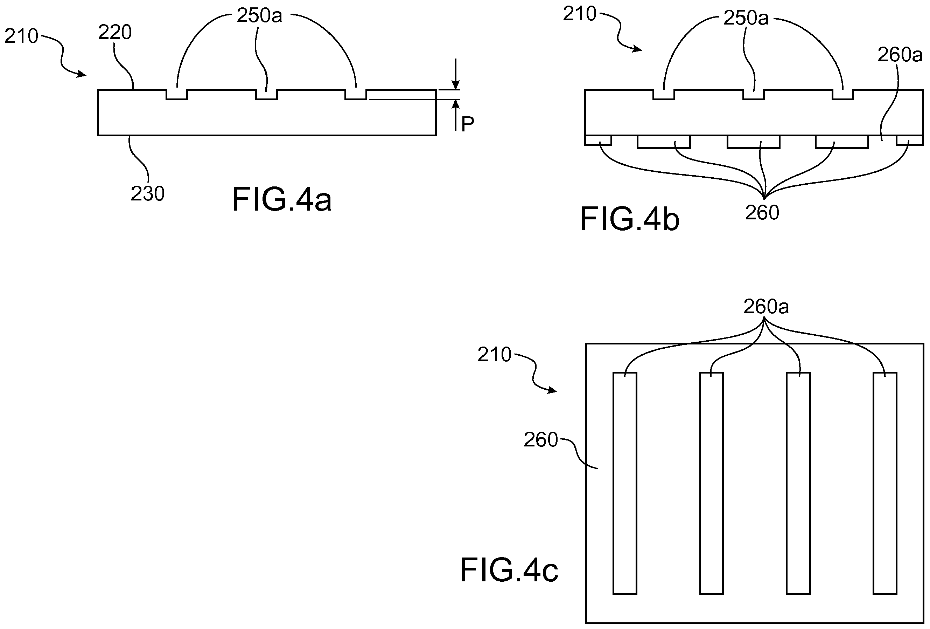

L'étape de fragilisation comprend la formation de tranchées 250a le long des lignes de coupe 250 d'une cellule photovoltaïque 210, ceci permettant de faciliter une étape b. comprenant un clivage (figure 4). Les tranchées 250a s'étendent sur une profondeur P, à partir de la première face 220 ou de la seconde face 230, comprise entre 2,5 % et 50 % de l'épaisseur totale de la cellule photovoltaïque 210 et avantageusement entre 5% et 20% de l'épaisseur totale.

Ainsi, dans cette gamme de profondeurs P, l'intégrité mécanique de la cellule photovoltaïque 210 est préservée jusqu'à l'étape b. de découpe. Par ailleurs, dès lors que l'étape a1 de fragilisation est exécutée, l'étape b. de découpe comprend avantageusement un clivage. En effet, un clivage peut être aisément exécuté à moindre coût sans apporter de modifications majeures d'une ligne d'assemblage de cellules photovoltaïques 210 préexistante.

L'étape a1. de fragilisation par formation de tranchées 250a peut être exécutée à l'aide d'un laser à impulsions. Par exemple, les conditions d'exécution de l'étape a1 peuvent être :
- longueur d'onde du LASER : 1064 nm ;
- fréquence des impulsions LASER : 7,5 kHz ;
- vitesse de balayage du LASER le long de la ligne de coupe : 15 mm.s⁻¹ ;
- intensité du courant alimentant le LASER : 24 A.
- puissance du laser : 7W

Ces conditions d'exécution de l'étape a1 ne sont données qu'à titre d'exemple et peuvent être modifiées par l'homme du métier dès lors qu'elle permet l'étape de clivage ultérieure tout en assurant la tenue mécanique.

La formation de tranchées 250a peut également être exécutée par d'autres méthodes. A titre d'exemple, nous pouvons citer :
- l'action d'une pointe diamantée, ou d'une roue diamantée, le long des lignes de coupe 250 ;
- une attaque par voie chimique (par exemple une solution de KOH ou de TMAH sur des cellules photovoltaïque 210 faites de silicium). Nous notons cependant que l'attaque par voie chimique doit être exécutée exclusivement au niveau des lignes de coupe 250, et peut donc nécessiter l'emploi de protections telles que des résines photosensibles.

De manière particulièrement avantageuse, l'étape a1. peut être exécutée avant l'étape a. Ainsi, le procédé selon l'invention peut être exécuté sans apporter de modifications majeures d'une ligne d'assemblage de cellules photovoltaïques 210 préexistante.

Le procédé selon l'invention peut également comprendre la mise en place d'un film de maintien 260 (illustré à la figure 4b) sur la seconde face 270 avant l'étape a. Le film de maintien 260 peut être fixé sur la seconde face 230 avec une colle (une couche adhésive).

Par exemple le film de maintien 260 peut comprendre :
- un empilement d'aluminium/PTFE/Polyester/Tissu avec une couche adhésive à base de silicon ;
- un film de polyimide avec une couche adhésive à base acrylique (ce type de film est par exemple commercialisé par la société 3M sous l'appellation KAPTON™).

La mise en place du film de maintien 260 est particulièrement avantageuse dès lors que l'étape a1. doit être exécutée (figure 4b). En effet, le film de maintien, en présence de tranchées 250a par exemple, permet de préserver l'intégrité mécanique des cellules photovoltaïques 210 lors de l'étape a.

Par ailleurs, un tel film de maintien 260 permet également d'envisager de former des tranchées 250a plus profondes. La présence du film de maintien permet également d'envisager une découpe complète du la cellule photovoltaïque 210 en sous-cellule 210a, par découpe laser par exemple.

Selon l'invention, le film de maintien 260 est pourvu d'ouvertures 260a de sorte que lors de l'exécution de l'étape a., les pistes conductrices 240 sont directement en contact électrique avec la seconde face 230 via lesdites ouvertures 260a (figure 4c).

Le procédé selon l'invention comprend également une étape c. de connexion électrique d'au moins deux sous-rangées 200a de sous-cellules 210a, de sorte que toutes les sous-cellules 210a des au moins deux sous-rangées 200a soient connectées en série.

L'étape c. peut alors être exécutée par connexion, tel que représenté à la figure 5, des extrémités desdites sous-rangées 200a par des techniques connues de l'homme du métier (les points C1, C2, et C3 de la figure 5 correspondent aux points de connexion de sous-rangées 200a).

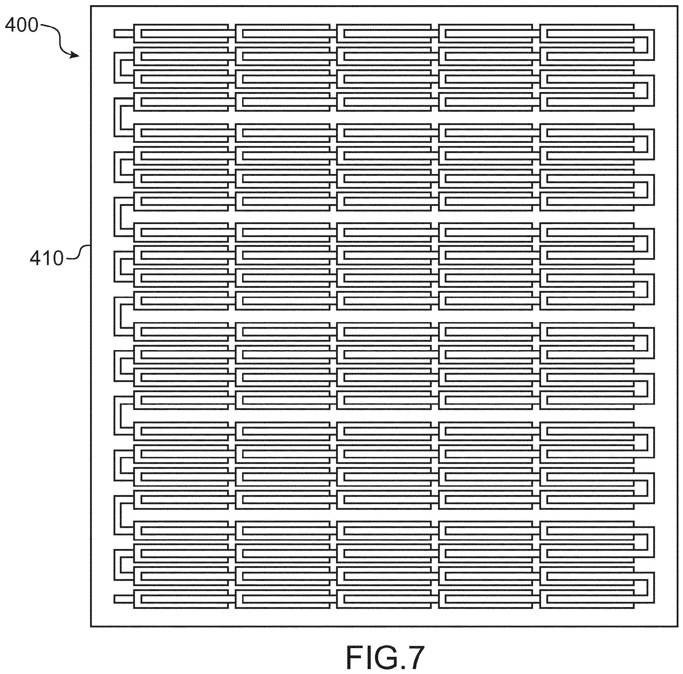

L'ensemble de sous-rangées 200a, formées à partir de rangées 200 selon l'invention (figure 7), peut être reporté sur un support transparent 410 de manière à former un panneau photovoltaïque 400. Le support transparent 410 peut être : une plaque de verre, une plaque polycarbonate, une plaque de poly(méthacrylate de méthyle).

Les sous rangées 200a peuvent être encapsulées dans un matériau d'encapsulation avant le report sur le support transparent 410. Le matériau d'encapsulation peut comprendre au moins un des matériaux choisi parmi : éthylène-acétate de vinyle, polyoléfine, poly(butyral vinylique), Ionomere, Silicone.

Le report des sous-rangées peut être suivi d'une étape de lamination destinée à enrober l'ensemble des sous-cellules photovoltaïques 210a disposée sur le support transparent 410.

Ainsi, le procédé selon l'invention permet d'augmenter la tension des panneaux photovoltaïques fabriqués sur des équipements initialement prévues pour la fabrication de panneau de plus faible tension.

Le procédé propose ainsi une découpe des cellules photovoltaïque après réalisation des interconnexions entre cellules disposées sous forme de rangées. Le découpe des cellules photovoltaïques en sous cellules 210a permet d'augmenter le nombre de « petites cellules » sur le panneau photovoltaïque, sans nécessairement manipuler un plus grand nombre de cellules photovoltaïques 210. Par ailleurs, le fait de considérer un plus grand nombre de sous-cellules 210a que de cellules 210 permet d'augmenter la tension du panneau photovoltaïque, sans pour autant augmenter le courant circulant dans les sous-cellules connectées en série. Par conséquent, il n'y a pas d'augmentation des pertes par effet Joule.

Le procédé selon l'invention permet également d'ajuster la transparence des panneaux photovoltaïques soit en ajustant l'espacement entre les sous-rangées 200a, soit en supprimant des sous-rangées 200a. Quelle que soit la solution envisagée, l'augmentation de la tension du panneau photovoltaïque reste effective.

Un intérêt supplémentaire est de pouvoir réemployer des centrales photovoltaïques existantes, en mais avec des modules ayant des caractéristiques de transparence différente. Par exemple, dans le cas agronomique où les cultures auront à changer ou à évoluer (exemple des serres photovoltaïques).

A titre d'exemple, nous présentons ici les caractéristiques d'un premier panneau photovoltaïque connu de l'état de la technique et d'un second panneau photovoltaïque, présentant les mêmes dimensions que le premier panneau, mais obtenu selon la présente invention.

Le premier panneau photovoltaïque connu de l'état de la technique peut avoir les caractéristiques suivantes :
- 60 cellules connectées en série, format 6 rangées (string) de 10 cellules,
- Tension en circuit ouvert Voc : 36-40V
- Courant Isc: 8A-9A

Le second panneau photovoltaïque est obtenu en supposant une découpe de chaque cellules photovoltaïques en quatre sous-cellules photovoltaïques, ainsi, nous obtenons un second panneau photovoltaïque comprenant 240 sous cellules photovoltaïques connectées en série permettant ainsi d'atteindre une tension en circuit ouvert comprise entre 144 V et 160 V, et un courant compris entre 2 A et 2,25 A.

La présente invention permet donc d'obtenir des panneaux photovoltaïques présentant une tension plus élevée, et débitant un courant plus faible, réduisant ainsi les pertes ohmiques.

### RÉFÉRENCES

[1] EP 2328182 A1;
[2] US 20150280028A1;
[3] US 20150280641A1;
[4] Agnes A. Mewe et al. "XIS: A Low-Current, High-Voltage Back-Junction Back-Contact Device", SiliconPV: March 25-27, 2013, Hamelin, Germany;
[5] J. Summhammer, "High voltage PV modules with crystalline silicon solar cells", proceedings of PVSEC Paris 2013;
[6] Alfred J. Baca et al. "Compact monocrystalline silicon solar modules with high voltage outputs and mechanically flexible designs", Energy& Environmental Science, Volume 3, Number 2, February 2010, Pages 165-240;
[7] Pablo Ortega et al., "High Voltage Photovoltaic Mini-modules", Prog. Photovolt: Res. Appl. 2008; 16:369-377;
[8] WO 2010/070573 A2;
[9] WO 96/17387.

## Revendications

1. Procédé de fabrication d'un élément photovoltaïque comprenant :
a) une étape de connexion électrique en série d'une pluralité de cellules photovoltaïques (210), comprenant une première face (220) et une seconde face (230), agencées selon une rangée (200), ladite rangée (200) s'étendant selon une direction E, la connexion entre deux cellules photovoltaïques (210) adjacentes étant assurée par une pluralité de pistes conductrices (240) ;
b) une étape de découpe, le long de lignes de coupe (250) disposées sur la première face (220), de chaque cellule photovoltaïque (210) en une pluralité de sous-cellules photovoltaïques (210a), l'étape de découpe étant exécutée selon la direction E de manière à former une pluralité de sous-rangées (200a) de sous-cellules photovoltaïques (210a), l'étape de découpe étant également exécutée de manière à ce que, dans chaque sous-rangée (200a), les sous-cellules (210a) sont connectées en série, l'étape b) comprenant un clivage des cellules photovoltaïques (210) par action mécanique au niveau des lignes de coupe (250) ;
c) une étape de connexion électrique d'au moins deux sous-rangées (200a) de sous-cellules (210a), de sorte que toutes les sous-cellules (210a) des au moins deux sous-rangées (200a) soient connectées en série,
le procédé comprend en outre une étape a1), précédant l'étape b), avantageusement l'étape a), ladite étape a1) étant une étape de fragilisation le long des lignes de coupe (250) de chaque cellule photovoltaïque (210),
l'étape a1) comprenant la formation de tranchées (250a) selon les lignes de coupe (250) dans les cellules photovoltaïques, avantageusement, la formation des tranchées (250a) étant exécutée par un traitement LASER, les tranchées (250a) s'étendant sur une profondeur P, à partir de la première face (220) ou de la seconde face (230), comprise entre 2,5 % et 50 % de l'épaisseur totale de la cellule photovoltaïque (210) et avantageusement entre 5% et 20% de l'épaisseur totale.

2. Procédé selon la revendication 1, dans lequel le procédé comprend la mise en place d'un film de maintien (260) sur la seconde face (270) avant l'étape a), des ouvertures (260a) étant ménagées dans le film de maintien pour permettre un contact électrique entre les pistes conductrices (240) et la seconde face (270).

3. Procédé selon la revendication 1 ou 2, dans lequel l'étape b) comprend un sciage des cellules photovoltaïques (210), avantageusement, le sciage est exécuté avec une scie à fil ou une scie diamantée.

4. Procédé selon l'une des revendications 1 à 3, dans lequel l'étape b) est exécutée de sorte à laisser un espacement entre les sous-rangées (200a).

5. Procédé selon l'une des revendications 1 à 4, dans lequel l'étape c) est précédée du retrait d'au moins une sous-rangée (200a) de manière à laisser un espace libre entre deux sous-rangées (220a).

6. Procédé de fabrication d'un panneau photovoltaïque comprenant la mise en place de sous-rangées (200a) de sous-cellules photovoltaïques (210a) sur un support transparent (280), électriquement connectées en série, et les sous-rangées (200a) de sous-cellules photovoltaïques (210a) étant obtenues selon l'une des revendications 1 à 5.

7. Procédé selon la revendication 6, dans lequel la mise place de sous-rangées (200a) de sous-cellules photovoltaïques (210a) est suivie d'une étape de lamination destinée à enrober l'ensemble des sous-cellules photovoltaïques (210a).

## Patentansprüche

1. Verfahren zur Herstellung eines photovoltaischen Elements, umfassend:
a) einen Schritt des elektrischen Verbindens in Reihe einer Vielzahl von photovoltaischen Zellen (210), die eine erste Fläche (220) und eine zweite Fläche (230) enthalten und in einer Reihe (200) angeordnet sind, wobei sich die Reihe (200) in einer Richtung E erstreckt, wobei die Verbindung zwischen zwei aneinandergrenzenden photovoltaischen Zellen (210) durch eine Vielzahl von Leiterbahnen (240) sichergestellt ist;
b) einen Schritt des Zerschneidens jeder photovoltaischen Zelle (210) entlang von auf der ersten Fläche (220) angeordneten Schnittlinien (250) in eine Vielzahl von photovoltaischen Unterzellen (210a), wobei der Schritt des Zerschneidens in der Richtung E durchgeführt wird, so dass eine Vielzahl von Unterreihen (200a) von photovoltaischen Unterzellen (210a) gebildet werden, wobei der Schritt des Zerschneidens auch so durchgeführt wird, dass in jeder Unterreihe (200a) die Unterzellen (210a) in Reihe verbunden sind, wobei der Schritt b) das Spalten der photovoltaischen Zellen (210) durch mechanische Einwirkung im Bereich der Schnittlinien (250) umfasst;
c) einen Schritt des elektrischen Verbindens von zumindest zwei Unterreihen (200a) von Unterzellen (210a), so dass alle Unterzellen (210a) der zumindest zwei Unterreihen (200a) in Reihe verbunden sind,
wobei das Verfahren ferner einen Schritt a1) vor dem Schritt b), vorteilhaft vor dem Schritt a) umfasst, wobei dieser Schritt a1) ein Schritt des Versprödens jeder photovoltaischen Zelle (210) entlang der Schnittlinien (250) ist,
wobei der Schritt a1) das Ausbilden von Gräben (250a) in den photovoltaischen Zellen entlang der Schnittlinien (250) umfasst, wobei das Ausbilden der Gräben (250a) vorteilhaft durch eine Laserbehandlung erfolgt, wobei sich die Gräben (250a) von der ersten Fläche (220) oder zweiten Fläche (230) aus über eine Tiefe zwischen 2,5 % und 50 % der Gesamtdicke der photovoltaischen Zelle (210) und vorteilhaft zwischen 5 % und 20 % der Gesamtdicke erstrecken.

2. Verfahren nach Anspruch 1, wobei das Verfahren vor dem Schritt a) das Anordnen einer Haltefolie (260) auf der zweiten Fläche (270) umfasst, wobei Öffnungen (260a) in die Haltefolie eingebracht werden, um einen elektrischen Kontakt zwischen den Leiterbahnen (240) und der zweiten Fläche (270) zu ermöglichen.

3. Verfahren nach Anspruch 1 oder 2, wobei der Schritt b) ein Zersägen der photovoltaischen Zellen (210) umfasst, wobei das Zersägen vorteilhaft mit einer Drahtsäge oder Diamantsäge erfolgt.

4. Verfahren nach einem der Ansprüche 1 bis 3, wobei der Schritt b) so ausgeführt wird, dass zwischen den Unterreihen (200a) ein Abstand gelassen wird.

5. Verfahren nach einem der Ansprüche 1 bis 4, wobei dem Schritt c) das Entfernen zumindest einer Unterreihe (200a) vorausgeht, so dass zwischen zwei Unterreihen (220a) ein Freiraum bleibt.

6. Verfahren zur Herstellung eines photovoltaischen Paneels, umfassend das Anordnen von Unterreihen (200a) von photovoltaischen Unterzellen (210a) auf einem transparenten Träger (280), die elektrisch in Reihe verbunden sind, wobei die Unterreihen (200a) von photovoltaischen Unterzellen (210a) nach einem der Ansprüche 1 bis 5 erhalten werden.

7. Verfahren nach Anspruch 6, wobei dem Anordnen von Unterreihen (200a) von photovoltaischen Unterzellen (210a) ein Schritt des Laminierens folgt, der dazu bestimmt ist, die Gesamtheit der photovoltaischen Unterzellen (210a) zu umhüllen.

## Claims

1. A method for manufacturing a photovoltaic element comprising:
a) a step of electrically connecting, in series, a plurality of photovoltaic cells (210), comprising a first face (220) and a second face (230), arranged in a row (200), said row (200) extending in a direction E, the connection between two adjacent photovoltaic cells (210) being ensured by a plurality of conductive tracks (240);
b) a step of cutting, along cutting lines (250) disposed on the first face (220), each photovoltaic cell (210) into a plurality of photovoltaic sub-cells (210a), the cutting step being carried out in the direction E so as to form a plurality of sub-rows (200a) of photovoltaic sub-cells (210a), the cutting step also being carried out so that, in each sub-row (200a), the sub-cells (210a) are connected in series, step b) comprising a cleavage of the photovoltaic cells (210) by mechanical action at the cutting lines (250);
c) a step of electrically connecting at least two sub-rows (200a) of sub-cells (210a), so that all the sub-cells (210a) of the at least two sub-rows (200a) are connected in series,
the method further comprises a step a1), preceding step b), advantageously step a), said step a1) being a step of weakening each photovoltaic cell (210) along the cutting lines (250),
step a1) comprising the formation of trenches (250a) along the cutting lines (250) in the photovoltaic cells, advantageously, the formation of the trenches (250a) being carried out by a LASER treatment
the trenches (250a) extending over a depth P, from the first face (220) or from the second face (230), comprised between 2.5% and 50% of the total thickness of the photovoltaic cell (210) and advantageously between 5% and 20% of the total thickness.

2. The method according to claim 1, wherein the method comprises placing a holding film (260) on the second face (270) before step a), openings (260a) being formed in the holding film to allow electrical contact between the conductive tracks (240) and the second face (270).

3. The method according to claim 1 or 2, wherein step b) comprises sawing the photovoltaic cells (210), advantageously, the sawing is carried out with a wire saw or a diamond saw.

4. The method according to one of claims 1 to 3, wherein step b) is carried out so as to leave a spacing between the sub-rows (200a).

5. The method according to one of claims 1 to 4, wherein step c) is preceded by the withdrawal of at least one sub-row (200a) so as to leave a free space between two sub-rows (220a).

6. A method for manufacturing a photovoltaic panel comprising placing sub-rows (200a) of photovoltaic sub-cells (210a) on a transparent support (280), which are electrically connected in series, and the sub-rows (200a) of photovoltaic sub-cells (210a) being obtained according to one of claims 1 to 5.

7. The method according to claim 6, wherein the placement of sub-rows (200a) of photovoltaic sub-cells (210a) is followed by a lamination step intended to coat all of the photovoltaic sub-cells (210a).
